# EUROPÄISCHE PATENTANMELDUNG

(11) **EP 1 589 659 A1**
(43) Veröffentlichungstag der Anmeldung: **26.10.2005**
(21) Anmeldenummer: 05006069.8
(22) Anmeldetag: 19.03.2005
(51) Int. Cl.: H03K 4/02

(54) **Verfahren zur Erzeugung eines Signals mit einem vorgebbaren Pulsdach**

(30) Priorität: 20.04.2004 DE 102004018986
(71) Anmelder: EADS Deutschland GmbH, 85521 Ottobrunn (DE)
(72) Erfinder: Lücke, Sven, 85716 Unterschleissheim (DE); Salomon, Andreas, 85716 Unterschleisseim (DE)
(74) Vertreter: Meel, Thomas

(57) **Zusammenfassung**

Die Erfindung betrifft ein Verfahren zur Erzeugung eines pulsförmigen Ausgangssendesignals mit einer vorgebbaren Pulsdachform in einer mehrstufigen Verstärkeranordnung. Erfindungsgemäß wird der Pegelwert des Pulsdachs des Sendesignals durch Ansteuersignale an den Verstärkerstufen bestimmt, wobei die Ansteuersignale der Verstärkerstufen jeweils vorgebbar sind, derart dass das Ansteuersignal einer Verstärkerstufe jeweils eine Anzahl von Pulsabschnitten (PA) eines vorgebbaren Rahmenpulses (2) umfasst, wobei die Pulsabschnitte (PA) jeweils einen vorgebbaren konstanten Pegelwertgradienten aufweisen.

## Beschreibung

Die Erfindung betrifft ein Verfahren zur Signalerzeugung gemäß dem Oberbegriff des Patentanspruchs 1.

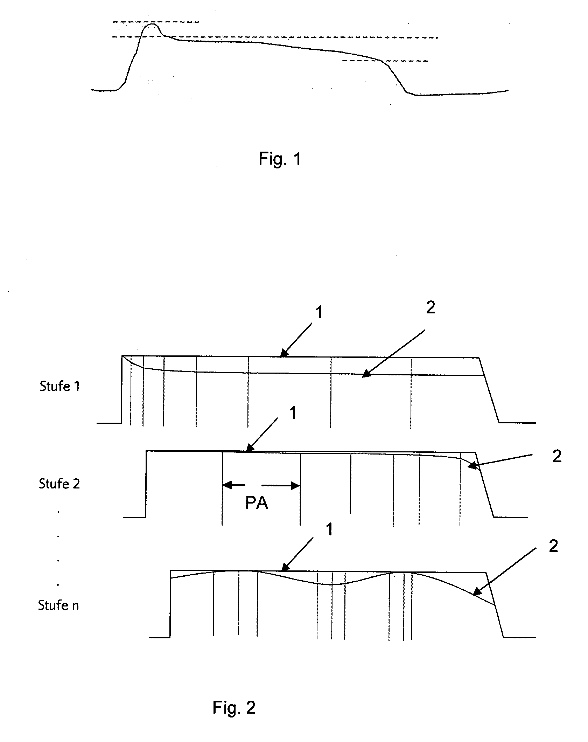

Aus dem Bericht "Fundamentals of RF and Microwave Power Measurement (Part 1)" von Agilent Technologies Inc. vom 17. April 2003 ist es bekannt, dass es bei mehrstufigen HF-Sendeverstärkern möglich ist, dass ein vom Sendeverstärker erzeugter Signalpuls nicht die gewünschte Pulsform aufweist. Eine nicht gewünschte Pulsform zeigt sich insbesondere in einem verzerrten Verlauf des Pulsdaches. Fig. 1 zeigt beispielhaft einen Signalpuls mit einem unerwünschten Pulsdachverlauf. Im Bereich des Pulsbeginns zeigt der Puls einen stark überschwingenden Verlauf, welcher im weiteren in einen stark abfallenden Verlauf übergeht. Diese unerwünschten Pulsverläufe führen dazu, dass die gesendeten Pulse nur schlecht detektiert werden können.

Verfahren und Schaltungen, mit denen pulsförmige Signale mit einem vorgebbaren Pulsdach erzeugt werden, sind aus DE 30 23 861 A1, DE 43 39 191 A1, DE 29 04 011 B2 und DE 198 56 800 C1 bekannt. Eine Pulsformung über einen hohen Dynamikbereich hinweg findet hier allerdings nicht statt.

Es ist somit Aufgabe der Erfindung, ein Verfahren anzugeben, mit dem es möglich ist, über einen hohen Dynamikbereich hinweg einen Puls mit einer vorgebbaren Pulsdachform zu erzeugen.

Diese Aufgabe wird mit dem Verfahren gemäß den Merkmalen des Anspruchs 1 gelöst. Vorteilhafte Ausführungen sind Gegenstand von Unteransprüchen.

Erfindungsgemäß wird der Pegelwert des Pulsdachs des Sendesignals durch Ansteuersignale an den Verstärkerstufen bestimmt, wobei die Ansteuersignale der Verstärkerstufen jeweils vorgebbar sind, derart dass das Ansteuersignal einer Verstärkerstufe jeweils eine Anzahl von Pulsabschnitten eines vorgebbaren Rahmenpulses umfasst, wobei die Pulsabschnitte jeweils einen vorgebbaren konstanten Pegelwertgradienten aufweisen.

Mit dem erfindungsgemäßen Verfahren wird somit eine Art Vorverzerrung für das Pulsdach vorgenommen. Diese Vorverzerrungen werden auf alle Ansteuersignale der jeweiligen gewünschten Verstärkerstufen, welche vorteilhaft emittermodulierte Verstärkerstufen sind, gebracht, wodurch ein Ausgangssendesignal mit der gewünschten Pulsdachform erzeugt wird.

Der Rahmenpuls einer einzelnen Verstärkerstufe mit z.B. einer Pulslänge von 32µs wird vorteilhaft digital geformt und anschließend analog gewandelt. Der Rahmenpuls umfasst erfindungsgemäß einzelne Pulsabschnitte, wobei die Zahl der Pulsabschnitte frei wählbar ist. Die einzeln geformten Rahmenpulse der Verstärkerstufen führen zu einem optimalen Pulsverlauf des Ausgangssendepulses.

Die einzelnen Pulsabschnitte des Rahmenpulses weisen vorteilhaft einen negativen oder positiven Pegelwertgradient auf. Dadurch ist es möglich, eine derartige Vorverzerrung zu generieren, dass das zu verstärkende Pulssignal in diesem Bereich des Pulses derart verstärkt wird, dass das Ausgangssendesignal genau in diesem Bereich den gewünschten Pulsdachvelauf aufweist. Dadurch ist es somit möglich, dass im Pulsverlauf des zu verstärkenden Pulssignals unerwünschte Signalverläufe eliminiert werden.

Es ist insbesondere möglich, dass die einzelnen Pulsabschnitte des Rahmenpulses gleiche oder unterschiedliche Längen aufweisen.

Die Erfindung wird anhand von Zeichnung näher erläutert. Es zeigen:
- Fig. 2: mehrere beispielhafte Rahmenpulse mit einer beispielhaften Anzahl von Pulsabschnitten
- Fig. 3: einen beispielhaften RF-Puls ohne Vorverzerrung des Pulsdaches und
- Fig. 4: den RF-Puls aus Fig. 3 mit Vorverzerrung des Pulsdaches.

Fig. 2 zeigt mehrere beispielhafte Rahmenpulse für sie Stufen 1 bis n mit einer beispielhaften Anzahl von Pulsabschnitten PA. Mit dem Bezugszeichen 1 ist der Rahmenpuls ohne Vorverzerrung gezeigt und mit dem Bezugszeichen 2 ist der Rahmenpuls mit Vorverzerrung gezeigt. Innerhalb der einzelnen Pulsabschnitte PA weist der Rahmenpuls 2 jeweils einen Pegelwert mit einem konstanten Gradienten auf.

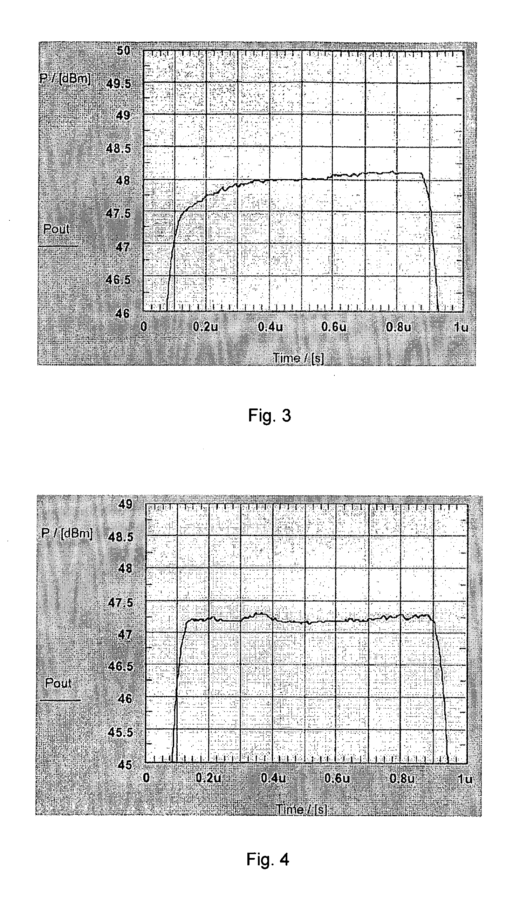

Fig. 3 zeigt einen beispielhaften RF-Puls ohne Vorverzerrung des Pulsdaches. Deutlich ist die lange Anstiegszeit der steigenden Pulsflanke zu erkennen, die den Verlauf des Pulsdaches unerwünscht beeinflußt. Fig. 4 zeigt den Puls aus Fig. 3 mit einer Vorverzerrung des Pulsdaches. Dabei wurde der Puls in der Endstufe des mehrstufigen Verstärkers mit einem vorverzerrten Ansteuerpuls verstärkt, dessen Verlauf dem in Fig. 2 entspricht. Diese Verstärkung bewirkt eine deutlich sichtbare Beeinflussung des Ausgangssendepulses. Nach Vornahme der Vorverzerrung wird sodann wieder die gewünschte RF-Pulsleistung eingestellt.

## Patentansprüche

1. Verfahren zur Erzeugung eines pulsförmigen Ausgangssendesignals mit einer vorgebbaren Pulsdachform in einer mehrstufigen Verstärkeranordnung, **dadurch gekennzeichnet, dass**
der Pegelwert des Pulsdachs des Sendesignals durch Ansteuersignale an den Verstärkerstufen bestimmt wird, wobei die Ansteuersignale der Verstärkerstufen jeweils vorgebbar sind, derart dass das Ansteuersignal einer Verstärkerstufe jeweils eine Anzahl von Pulsabschnitten (PA) eines vorgebbaren Rahmenpulses (2) umfasst, wobei die Pulsabschnitte (PA) jeweils einen vorgebbaren konstanten Pegelwertgradienten aufweisen.

2. Verfahren nach Anspruch 1, wobei die Verstärkerstufen emittermoduliert sind.

3. Verfahren nach einem der vorangehenden Ansprüche, wobei der Rahmenpuls (2) digital geformt und anschließend analog gewandelt wird.

4. Verfahren nach einem der vorangehenden Ansprüche, wobei der Pegelwertgradient in den einzelnen Pulsabschnitten (PA) des Rahmenpulses (2) negativ oder positiv ist.

5. Verfahren nach einem der vorangehenden Ansprüche, wobei die Pulsabschnitte (PA) gleiche oder unterschiedliche Pulslängen aufweisen.

6. Verfahren nach einem der vorangehenden Ansprüche, wobei der Rahmenpuls (2) eine vorgebbare Pulslänge von bis zu 32µs aufweist.

7. Verfahren nach einem der vorangehenden Ansprüche, wobei die Zahl der Rahmenpulse (2) der Zahl der Verstärkerstufen entspricht.
